# EUROPEAN PATENT APPLICATION

(11) **EP 0 798 763 A2**
(43) Date of publication of application: **01.10.1997**
(21) Application number: 97104793.1
(22) Date of filing: 20.03.1997
(51) Int. Cl.: H01L 21/00

(54) **Method and apparatus of transferring wafers**

(30) Priority: 25.03.1996 JP 67993/96; 10.03.1997 JP 54493/97
(71) Applicant: Shin-Etsu Handotai Co., Ltd, Chiyoda-ku Tokyo (JP)
(72) Inventor: Miyazaki, Yasushi, Nagano-shi, Nagano-ken (JP)
(74) Representative: Patentanwälte Leinweber & Zimmermann

(57) **Abstract**

A wafer transferring apparatus for transferring wafers between two wafer holding jigs, comprising a plurality of wafer transferring machines which are connected to one another and movable close to and away from one another, each of the wafer transferring machines comprising an arm which is movable back and forth and a pair of grasping members openably and closably attached to a distal end of the arm to grasp and release the wafers.

## Description

### BACKGROUND OF THE INVENTION

### 1. Field of the Invention

The present invention relates to a method and an apparatus for freely transferring wafers such as semiconductor wafers, for instance, silicon wafers and gallium-arsenide wafers, and quartz wafers between two wafer holding jigs, such as wafer carriers or wafer boats.

### 2. Description of the Related Art

In the processes of manufacturing semiconductor wafers, such as surface oxidation and impurity diffusion, wafers arranged in a wafer carrier are transferred to a wafer boat for processing and then returned from the wafer boat to the wafer carrier after the completion of the processing. Generally, a wafer transferring apparatus is known as a means for transferring wafers from one wafer holding jig such as a wafer carrier or wafer carriers to another wafer holding jig such as a wafer boat or wafer boats.

As shown in Figs. 8 and 9, the conventional wafer transferring apparatus 32 has an arm 34, a pair of grasping members 36, 36 openably and closably attached to one distal end of the arm 34 to grasp and release wafers, and a pair of holding members 38, 38 respectively attached to both the bottom ends of grasping members 36, 36 to hold the wafers. The wafer transferring apparatus 32 can move up and down, back and forth, and right and left. Further, the arm 34 per se can move back and forth.

A plurality of grooves (not shown) are formed in each inner face of the holding members 38, 38 along the longitudinal direction. Each pair of grooves are arranged to receive opposite points of the peripheral portion of each wafer.

Referring to Fig. 10, operation of the wafer transferring apparatus 32 will be described on the case of transferring wafers (W) held in wafer holding portions 42 of three wafer carriers 40 to wafer receiving portions 46 of one wafer boat 44.

The wafer transferring apparatus 32 is moved to a place over the wafer carriers 40, with the grasping members 36, 36 being opened right and left, respectively. Thereafter, the wafer transferring apparatus 32 is lowered to a position such that the grasping members 36, 36 can grasp the wafers (W) loaded in the wafer carriers 40.

Next, the grasping members 36, 36 are closed to grasp the wafers (W) by the holding members 38, 38. The wafer transferring apparatus 32 is then elevated and moved to a place over the wafer boat 44, with the wafers (W) being held by the holding members 38, 38. Thereafter, the apparatus 32 is lowered to a position such that the outer edges of the wafers (W) can reach the wafer receiving portions 46. In such a state, when the grasping members 36, 36 are respectively opened right and left, the wafers (W) are detached from the holding members 38, 38 and arranged in the wafer receiving portions 46, respectively. Thus, the wafers (W) are transferred from the wafer carriers 40 to the wafer boat 44.

In Fig. 10, the outermost wafers of the three groups of wafers (W) respectively received in the three wafer carriers 40 are arranged at opposing intervals (a), and the wafers (W) received in each of the wafer carrier 40 are opposite to each other with predetermined spaces (b).

With the above mentioned arrangement, when the wafers (W) are transferred in such a manner as described above from the wafer carriers 40 to the wafer boat 44 by the conventional wafer transferring apparatus 32, they are transferred in such a state that the opposing intervals (a) between the outermost wafers of the groups of the wafers (W) and the spaces (b) between the wafers (W) are kept unchanged, respectively.

There is no problem when the opposing interval (a) and the space (b) are equal. However, if the opposing interval (a) is considerably larger than the space (b) as shown in Fig. 10, empty areas (A) exist in the wafer receiving portions 46 of the wafer boat 44. Therefore, as the empty areas (A) exist, the number of wafers (W) to be loaded in the wafer boat 44 decreases, whereby the working efficiency is disadvantageously lowered to that extent.

Moreover, there is generally known a conventional method wherein transferring operation of wafers is conducted for each wafer carrier and hence for a plurality of wafer carriers the above operation is repeated plural times. In this case, the transferring operation takes a considerably long time.

### SUMMARY OF THE INVENTION

With the foregoing problems in view, it is an object of the present invention to provide a method and an apparatus which can transfer wafers from a first wafer holding jig comprising a plurality of wafer carriers or the like to a second wafer holding jig comprising a wafer boat or the like or vice versa, that is, from the second wafer holding jig to the first wafer holding jig at a time without forming empty areas in the second wafer holding jig, so that significant reduction of the transferring time, increase of the number of wafers to be loaded on the wafer holding jig and downsizing of the wafer holding jig can be achieved.

In one aspect, the present invention provides a wafer transferring apparatus for transferring wafers between two wafer holding jig comprising a plurality of wafer transferring machines which are connected to one another and movable close to and away from one another, each of the wafer transferring machines comprising an arm which is movable back and forth and a pair of grasping members openably and closably attached to a distal end of the arm to grasp and release the wafers.

In another aspect, the present invention provides a wafer transferring method for transferring wafers between two wafer holding jigs using the apparatus specified above comprising the steps of: moving a plurality of the wafer transferring machines to a place over a first wafer holding jig comprising a plurality of first wafer holding members of the same number as the wafer transferring machines, with keeping setup intervals of the wafer transferring machines respectively corresponding to the opposing intervals of the first wafer holding members; lowering the wafer transferring machines to grasp all wafers in the first wafer holding jig by each pairs of the grasping members; elevating the wafer transferring machines which grasp the wafers and getting them close to one another to reduce or eliminate the setup intervals; and moving the wafer transferring machines to a place of a second wafer holding jig comprising a second wafer holding member so as to release the wafers from the grasping members and arrange them in the second wafer holding jig.

In still another aspect, the present invention provides a wafer transferring method for transferring wafers between two wafer holding jigs using the wafer transferring apparatus according to claim 1, comprising the steps of: moving a plurality of the wafer transferring machines to a place over a second wafer holding jig comprising a second wafer holding member with keeping the wafer transferring machines close to one another to reduce or eliminate setup intervals between the wafer transferring machines; lowering the wafer transferring machines to grasp all wafers in the second wafer holding jig by each pairs of the grasping members; elevating the wafer transferring machines which grasp the wafers and keeping them apart from one another to form the setup intervals between the wafer transferring machines respectively corresponding to opposing intervals between the first wafer holding members; and moving the wafer transferring machines to a place of a first wafer holding jig comprising a plurality of first wafer holding members of the same number as the wafer transferring machines so as to release the wafers from the grasping members and arrange them in the first wafer holding jig.

As the wafer holding jig, a wafer carrier or a wafer boat can be mentioned.

The above and other objects, features and advantages of the present invention will become manifest to those versed in the art on making reference to the detailed description and the accompanying sheets of drawings.

### BRIEF DESCRIPTION OF THE DRAWINGS

Fig. 1 is a front elevation of one embodiment of a wafer transferring mechanism including the wafer transferring apparatus according to the present invention;
Fig. 2 is a side elevation of the mechanism shown in Fig. 1;
Fig. 3 is a top view of the mechanism shown in Fig. 1;
Fig. 4 is a schematic diagram of another embodiment of the wafer transferring apparatus according to the present invention, which comprises three wafer transferring machines;
Fig. 5 is a schematic diagram showing a state in which the three wafer transferring machines of Fig. 4 are close to one another;
Fig. 6 is a schematic side elevation of the wafer transferring machine of Fig. 4;
Fig. 7 is a schematic diagram showing a state in which wafers arranged in wafer carriers are transferred to a wafer boat according to the method of the present invention;
Fig. 8 is a schematic diagram showing one example of a conventional wafer transferring apparatus;
Fig. 9 is a schematic side elevation of the wafer transferring apparatus shown in Fig. 8; and
Fig. 10 is a schematic diagram showing a state in which wafers arranged in wafer carries are transferred to a wafer boat according to the conventional method.

### DETAILED DESCRIPTION

The present invention will be described below in greater detail by way of the following embodiments which should be construed as illustrative rather than restrictive.

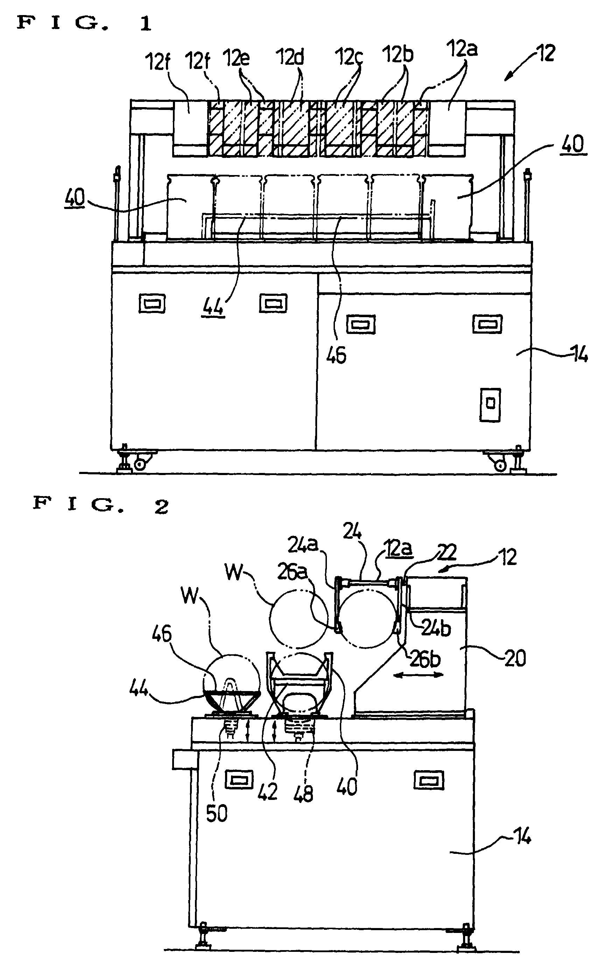

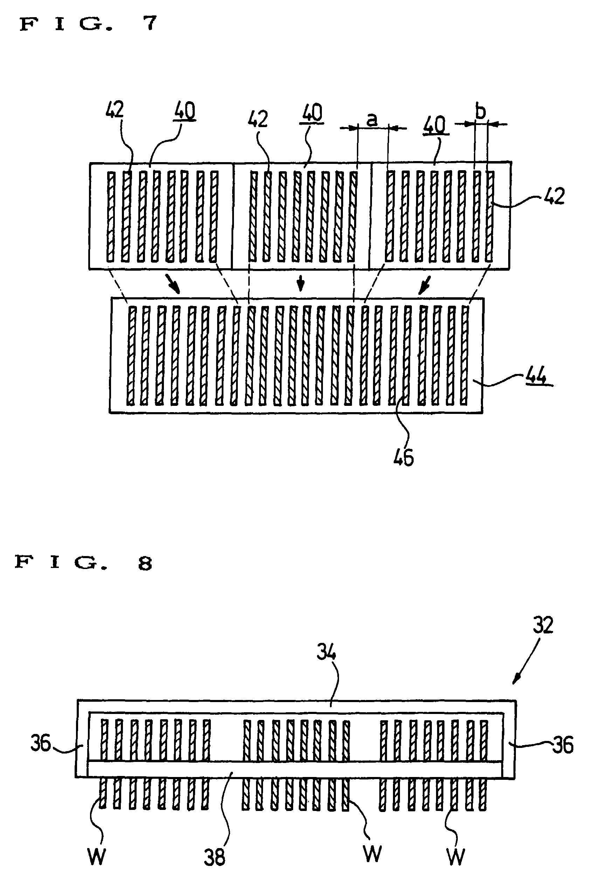

In Figs. 1 to 3, wafer transferring apparatus 12 according to the present invention comprises a plurality of wafer transferring machines 12a to 12f which are connected to one another and movable close to and away from one another. In the embodiment of the drawings, the wafer transferring apparatus 12 is set on a base 14 together with wafer carriers 40 and a wafer boat 44.

The wafer carrier 40 has wafer holding portions 42, and the wafer boat 44 has wafer receiving portions 46. Reference numeral 48 designates a wafer pushing up member which is provided below the wafer holding portions 42, and reference numeral 50 denotes another wafer pushing up member provided below the wafer receiving portions 46.

Further, designated by 20 is a movable block which is provided on the back end portion of the base 14 and movable back and forth. On the upper portion of the movable block 20 a plurality of wafer transferring machines 12a to 12f are attached in such a manner as they are connected to one another and movable close to and away from one another. Namely, the wafer transferring apparatus 12 is movable back and forth with the movement of the movable block 20.

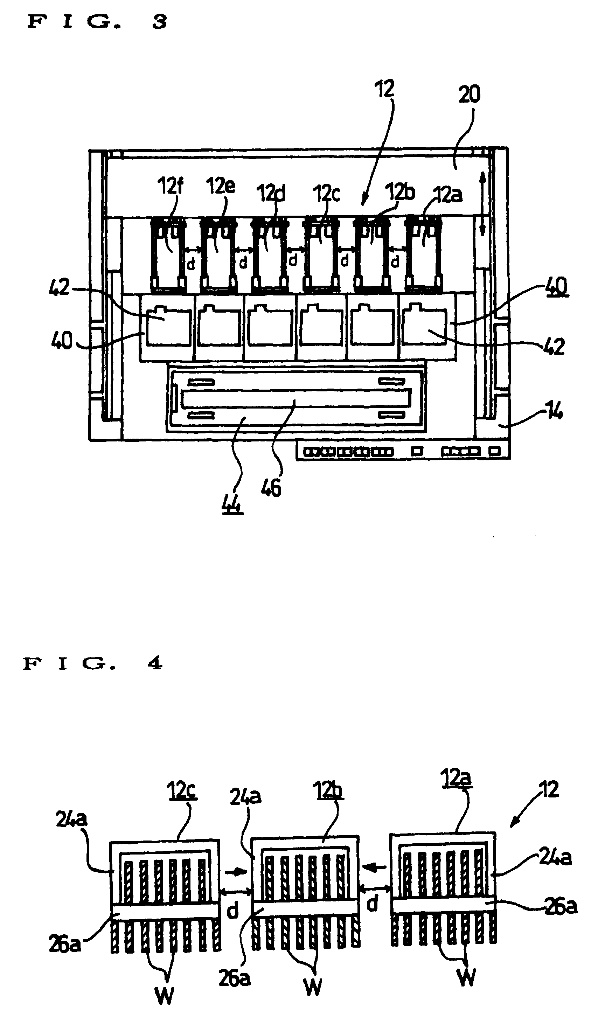

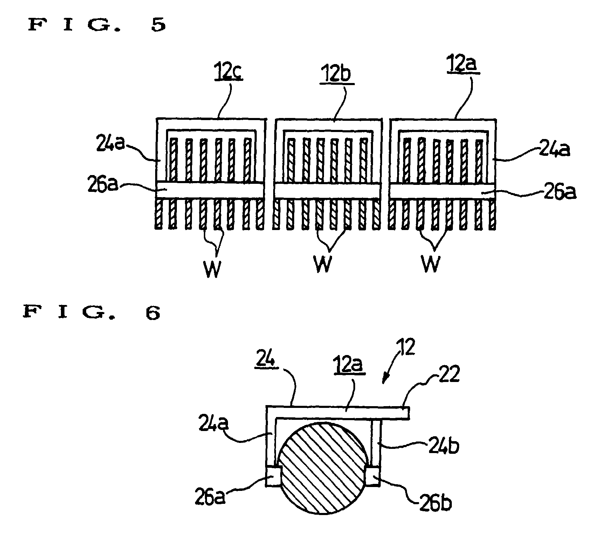

As shown in Fig. 2, numeral 22 is an arm of the wafer transferring machine 12a which is provided movably right and left on the upper part of the movable block 20 and movable back and forth together with the wafer transferring machine 12a. Designated by 24 is a hand portion which is attached openably and closably to the distal end of the arm 22. The hand portion 24 includes a pair of opposing grasping members 24a, 24b which are movable close to and away from each other.

A pair of holding members 26a, 26b are attached to the bottom ends of the grasping members 24a, 24b, respectively. A plurality of grooves (not shown) are formed in each inner face of the holding members 26a, 26b. Each pair of grooves is arranged to receive opposite points of the peripheral portion of each wafer.

With the above arrangement, operation of the wafer transferring apparatus 12 will be described on the case of transferring wafers (W) held in the wafer holding portions 42 of a plurality of the wafer carriers 40 provided one another with opposing intervals (a) to the wafer receiving portions 46 of the wafer boat 44.

The plural wafer transferring machines 12a to 12f are moved to a place over the corresponding wafer carriers 40 with keeping setup intervals (d) between the wafer transferring machines 12a to 12f respectively corresponding to the opposing intervals (a) between the wafer carriers 40, the grasping members 24a, 24b being opened right and left, respectively. Thereafter, the wafer transferring machines 12a to 12f are lowered to such a position that the holding members 26a, 26b of the grasping members 24a, 24b can grasp the wafers (W) received in the corresponding wafer holding portions 42 of the wafer carriers 40, respectively. At the time, the wafers (W) received in the wafer holding portions 42 of the wafer carrier 40 are pushed upwards by the wafer pushing up member 48 so as to be grasped by the holding members 26a, 26b of the grasping members 24a, 24b.

Then, the grasping members 24a, 24b are closed each other to grasp the wafers (W) by the holding members 26a, 26b. The wafer transferring machines 12a to 12f are then elevated, with the wafers (W) being held therein. Thereafter, the wafer transferring machines 12a to 12f are brought close to one another to reduce or eliminate the setup intervals (d) therebetween and to thereby reduce or eliminate the opposing intervals (a) between the wafer carriers 40 (the dotted lines in Fig. 1 and Figs. 4 and 5).

The wafer transferring machines 12a to 12f which are close to each other are moved to a place over the wafer boat 44 and then lowered to such a position that the peripheral portion of each wafer (W) reaches the wafer receiving portions 46. In such a state, if the grasping members 24a, 24b are opened right and left, the wafers (W) are detached from the holding members 26a, 26b and received in the wafer receiving portions 46, respectively. Thus, the wafers (W) are transferred from the wafer carriers 40 to the wafer boat 44. In this case, the wafer carriers 40, the holding members 26a, 26b and the wafer boat 44 are provided with grooves of the same pitch for receiving the wafers (W).

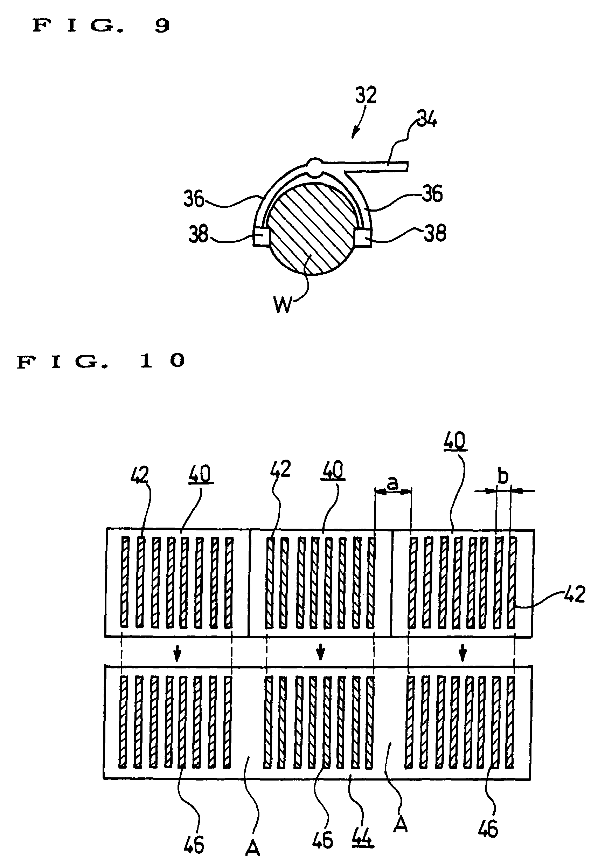

Next, the situation of the wafers in the middle course of the wafer transferring operation will be explained in accordance with the embodiment wherein there are provided three wafer carriers 40 shown in Figs. 4-7. In Fig. 7, similar to the case of Fig. 10, the outermost wafers of the three groups of wafers (W) received in the holding portions 42 of three wafer carriers 40 are arranged at opposing intervals (a), and the wafers (W) received in each wafer carrier 40 are in opposite to each other with a predetermined space (b).

With the above mentioned construction, when the wafers (W) are transferred from the three wafer carriers 40 to the wafer boat 44 by the wafer transferring apparatus 12 of the present invention as described above, the space (b) between the two opposing wafers (W) in each wafer carrier 40 is kept unchanged, while the opposing intervals (a) between the groups of wafers (W) are reduced as shown in Fig. 7. Thus, the empty areas (A) as shown in Fig. 10 do not exist in the case of Fig. 7. Therefore, the number of wafers (W) to be loaded in the wafer boat 44 can be increased, thereby improving the working efficiency as compared with the conventional wafer transferring apparatus.

The wafer transferring apparatus 12 of the present invention can also transfer contrary to the above embodiment the wafers (W) held in the wafer receiving portions 46 of the wafer boat 44 to the wafer holding portions 42 of a plurality of the wafer carriers 40 provided one another with opposing intervals (a). This wafer transferring operation will be described below briefly.

A plurality of the wafer transferring machines 12a to 12f are moved to a place over the wafer boat 44 with keeping the wafer transferring machines close to one another to reduce or eliminate setup intervals (d) therebetween, the grasping members 24a, 24b being opened right and left, respectively. Thereafter, the wafer transferring machines 12a to 12f are lowered to such a position that the holding members 26a, 26b of the grasping members 24a, 24b can grasp the wafers (W) received in the wafer receiving portions 46 of the wafer boat 44, respectively. At this time, the wafers (W) received in the wafer receiving portions 46 of the wafer boat 44 are pushed upwards by the wafer pushing up member 50 so as to be grasped by the holding members 26a, 26b of the grasping members 24a, 24b.

Then, the grasping members 24a, 24b are closed each other to grasp the wafers (W) by the holding members 26a, 26b. The wafer transferring machines 12a to 12f are then elevated, with the wafers (W) being held therein. Thereafter, the wafer transferring machines 12a to 12f are kept apart from one another to form the setup intervals (d) therebetween respectively corresponding to the opposing intervals (a) between the wafer carriers 40.

The wafer transferring machines 12a to 12f which are kept apart with the setup intervals (d) from one another are moved to a place over the plural wafer carriers 40 and then lowered to such a position that the peripheral portion of each wafer (W) reaches the wafer holding portions 42 of the wafer carriers 40. In such a state, if the grasping members 24a, 24b are opened right and left, the wafers (W) are detached from the holding members 26a, 26b and received in the wafer holding portions 42, respectively. At this time, with the wafer pushing up member 48 being in advance put in an upper position, after the wafers (W) which are detached from the holding members 26a, 26b are received in the wafer pushing up member 48, the wafer pushing up member 48 is lowered, thereby the wafers (W) being held by the wafer holding portions 42, preferably. Thus, according to the present invention, the wafers (W) can be easily transferred from the wafer boat 44 to the wafer carriers 40.

There are described above the embodiments wherein the apparatus and the method of the present invention are applied to a wafer boat for a horizontal furnace holding wafers vertically. The present invention is also applicable to a wafer boat for a vertical furnace holding wafers horizontally.

As stated above, according to the present invention, it becomes possible to transfer wafers from a first wafer holding jig comprising a plurality of wafer carriers or the like to a second wafer holding jig comprising one wafer boat or the like or vice versa, that is, from the second wafer holding jig to the first wafer holding jig at a time without forming any empty areas in the second wafer holding jig and hence reduction of the transferring time, increase of the number of wafers to be loaded on the wafer holding jig and downsizing of the wafer holding jig can be achieved.

Obviously, various modifications and variations of the present invention are possible in the light of the above teaching. It is therefore to be understood that within the scope of the appended claims the invention may be practiced otherwise than as specifically described.

## Claims

1. A wafer transferring apparatus for transferring wafers between two wafer holding jigs, comprising a plurality of wafer transferring machines which are connected to one another and movable close to and away from one another, each of the transferring machines comprising an arm which is movable back and forth and a pair of grasping members openably and closably attached to a distal end of the arm to grasp and release the wafers.

2. A wafer transferring apparatus according to claim 1, wherein the wafer holding jig is a wafer carrier or a wafer boat.

3. A method of transferring wafers between two wafer holding jigs using the wafer transferring apparatus according to claim 1 or 2, comprising the steps of: moving a plurality of the wafer transferring machines to a place over a first wafer holding jig comprising a plurality of first wafer holding members of the same number as the wafer transferring machines with keeping setup intervals between the wafer transferring machines respectively corresponding to opposing intervals between the first wafer holding members; lowering the wafer transferring machines to grasp all wafers in the first wafer holding jig by each pairs of the grasping members; elevating the wafer transferring machines which grasp the wafers and getting them close to one another to reduce or eliminate the setup intervals; and moving the wafer transferring machines to a place of a second wafer holding jig comprising a second wafer holding member so as to release the wafers from the grasping members and arrange them in the second wafer holding jig.

4. A method of transferring wafers between two wafer holding jigs using the wafer transferring apparatus according to claim 1 or 2, comprising the steps of: moving a plurality of the wafer transferring machines to a place over a second wafer holding jig comprising a second wafer holding member with keeping the wafer transferring machines close to one another to reduce or eliminate setup intervals between the wafer transferring machines; lowering the wafer transferring machines to grasp all wafers in the second wafer holding jig by each pairs of the grasping members; elevating the wafer transferring machines which grasp the wafers and keeping them apart from one another to form the setup intervals between the wafer transferring machines respectively corresponding to opposing intervals between the first wafer holding members; and moving the wafer transferring machines to a place of a first wafer holding jig comprising a plurality of first wafer holding members of the same number as the wafer transferring machines so as to release the wafers from the grasping members and arrange them in the first wafer holding jig.

5. A method according to claim 3 or 4, wherein the first wafer holding jig is composed of a plurality of wafer carriers and the second wafer holding jig is a wafer boat.
